Europäisches Patentamt

European Patent Office

Office européen des brevets

(19)

(11) EP 0 756 309 A1

## (12) EUROPEAN PATENT APPLICATION

(43) Date of publication:
29.01.1997 Bulletin 1997/05

(51) Int Cl.⁶: H01J 37/32

(21) Application number: 96305437.4

(22) Date of filing: 24.07.1996

(84) Designated Contracting States:
AT BE CH DE ES FR GB GR IE IT LI NL SE

(30) Priority: 26.07.1995 US 507726

(71) Applicant: APPLIED MATERIALS, INC.
Santa Clara, California 95052 (US)

(72) Inventors:
• Collins, Kenneth S.
San Jose, California 95111 (US)

• Ishikawa, Tetsuya
Santa Clara, California 95050 (US)

(74) Representative: Bayliss, Geoffrey Cyril et al
BOULT, WADE & TENNANT
27 Furnival Street
London EC4A 1PQ (GB)

### (54) Plasma systems for processing substrates

(57) A plasma system for processing a substrate (20) including a chamber body (12) defining a plasma cavity (16) therein; a first antenna (46) configured and positioned relative to the plasma cavity so as to produce, when used by itself, a centre-peaked plasma density profile above the substrate during operation; and a second antenna (42) configured and positioned relative to the plasma chamber so as to produce, when used by itself, a hollow-centred plasma density profile above the substrate during operation. When the two antennas are used in combination a uniform plasma density profile is produced across the top of the substrate.

FIG. 1

Printed by Jouve, 75001 PARIS (FR)

**Description**

The invention relates to a plasma source for which the density profile can be controlled.

Inductively coupled sources are used to generate a high density plasma ($n_e \sim 1 \times 10^{11}$ - $2 \times 10^{12}/cm^3$) at low energy ($T_e \sim$ few eV) for etching or deposition of materials. A side or top coil antenna (or a variation in between) is deployed adjacent to a dielectric window that forms one boundary of a vacuum chamber, and an RF current is applied to the coil antenna. A plasma may be created when the electrostatic field generated by the antenna voltage fringing into the dielectric-window-bounded vacuum chamber is sufficiently high. Further increasing RF current applied to the antenna may result in a dominantly inductively coupled high density plasma when the induced electric field exceeds a threshold.

Typically, the antenna type and source geometry (e.g. shape and size) are optimized for a particular process and operating regime. However, this may limit the process operating window for a particular hardware configuration. For example, a plasma source optimized for operation at low pressure (<5 mtorr) in an electropositive plasma may have a very flat plasma density profile over a large area while operated at low pressure, but uniformity may degrade when operating at higher pressures, or with electronegative gas

Uniformity degradation is due to poorer electron diffusion inward from the region into which power is coupled adjacent to the antenna. Poor electron diffusion is due to the increased frequency of electron collisions which occurs as a result of the higher pressures. In the case of high power source operation, poor penetration of the plasma is also due to reduced penetration of the induced RF E-field (i.e., a smaller skin depth due to higher plasma conductivity). Both of these effects result in a "hollow-center" density profile. In addition, electronegative plasmas (e.g. a plasma in an atmosphere containing fluorine, chlorine, or oxygen) can also produce hollow-center density profiles.

Various techniques are used to prevent the degradation in plasma density uniformity for particular process conditions. For example, for some plasma processes a tall source will be used and for others a short source will be used. Increasing the height of the source tends to increase wall losses and this compensates for hollow center. Decreasing the height increases tends to increase end losses to the electrodes and this reduces plasma density in the center of the substrate. Also, electrode spacing has some effect on plasma uniformity and can be selected for a specific process and process conditions to produce better uniformity. It is also possible to affect uniformity by adjusting flow rates within the chamber. But this latter approach also tends to drastically affect the process. In addition, many of these techniques which are tailored to the particular plasma process that is being performed will not produce the desired results if process conditions are changed.

In general, in one aspect, the invention is a plasma system which includes a chamber body defining a plasma cavity therein; a first antenna configured and positioned relative to the plasma cavity so as to produce a center-peaked plasma density profile above the substrate during operation; and a second antenna configured and positioned relative to the plasma chamber so as to produce a hollow-centered plasma density profile above the substrate during operation.

Preferred embodiments include the following features. The plasma system also includes a power source connected to both the first and the second antennas. The ppower source delivers delivering power (e.g. RF power) to both the first and second antennas during operation and produces a net plasma density profile above the substrate. The power source includes an RF generator and the plasma system further includes a power splitter which receives power from the RF generator and distributes (or splits) the received power to the first and second antennas. Alternatively, the power source can include a first RF generator delivering power to the first antenna and a second RF generator delivering power to the second antenna.

Also in preferred embodiments, both of the first and second antennas are located outside of the plasma cavity. The chamber body includes a first dielectric window and a second dielectric window and the first antenna is located outside of the plasma cavity and adjacent to the first dielectric window and the second antenna is located outside of the plasma cavity and adjacent to the second dielectric window. The first and second antennas are coil antennas. For example, the first antenna might be a flat spiral coil antenna that is located substantially parallel to the substrate during operation and the second antenna is a cylindrically shaped coil wound around a cylindrically-shaped body which acts as a dielectric windows are made of quartz.

In general, in another aspect, the invention is a plasma system inclkuding a chamber body defining a plasma cavity having a central inner region surrounded by an outer region; a first antenna configured and positioned relative to the plasma cavity so as to couple energy more effectively into the central region than into the outer region; and a second antenna configured and positioned relative to the plasma chamber so to couple energy more effectively into the outer region than into the central region.

In preferred embodiments, the chamber body includes a dielectric window located above the substrate and the first and second antennas are located outside of the plasma cavity and adjacent to the dielectric window. More specifically, the second antenna is concentrically positioned within the first antenna.

In general, in yet another aspect, the invention is a plasma system including a chamber body defining a plasma cavity; a first antenna positioned relative to the plasma cavity so as to couple energy during operation into a plasma within the cavity; a second antenna positioned relative to the plasma chamber so as to couple energy during operation into the plasma within the cavity; a power splitter having an input line and a first and a second output line, wherein the first output line is coupled to the first antenna and the second output line is coupled to the second antenna; and a power generator which provides power to the input line of the power splitter, wherein the power splitter distributes the power received from the power generator to its first and second output lines.

In general, in still another aspect, a method of controlling an ion density profile of a plasma within a plasma system for processing a substrate. The method includes coupling first RF power into the plasma through a first antenna; coupling second RF power into the plasma through a second antenna; and controlling a ratio of the first RF power to the second RF power so as to produce a substantially uniform ion density profile above the substrate during plasma processing.

Using the above described hardware, RF current may be split between top and side coil antennas to produce a flat plasma density profile, even across large wafer diameters. Furthermore, the phase of the currents in the antennas may be maintained at some desired constant value, to maintain constant inductive coupling relationship and capacitive coupling relationship between antenna coils and plasma, independent of the RF current split.

The invention offers numerous advantages. In general, it allows high pressure and high power operation of a plasma process (e.g. an etch process) and it allows operating with an electropositive or an electronegative plasma without experiencing excessive nonuniformity in the plasma density profile. In addition, it provides a plasma source which has a wider window of uniform density operation. It also allows the user to vary in real time the density profile over a wide range of process conditions. It also allows two or more antenna coils to be driven at the same or different RF currents and it allows the user to control the RF current split among the two or more antenna coils while maintaining a desired phase relationship between the currents or the resultant antenna voltages.

The invention is particularly useful for producing a more uniform ion plasma density profiles for plasma processing (e.g. plasma etching) of very large substrates.

Other advantages and features will become apparent from the following description of the preferred embodiment with reference to the accompanying drawings, in which:

Fig. 1 shows a cross-sectional view of a plasma etch system;
Fig. 2 shows a block diagram of the RF circuit for coupling RF power to the antennas and RF bias to the pedestal;
Fig. 3a shows details of one configuration for connecting the power splitter to the top and side antennas;
Fig. 3b shows details of another configuration for connecting the power splitter to the top and side antennas;
Figs. 4a-d show alternative designs for the two antennas and the chamber;
Fig. 5 shows the general configuration of a chamber that was used to obtain experimental data; and
Figs. 6a-c show plots of oxide etch results as a unction of location across the diameter of a wafer for three different splitter control currents.

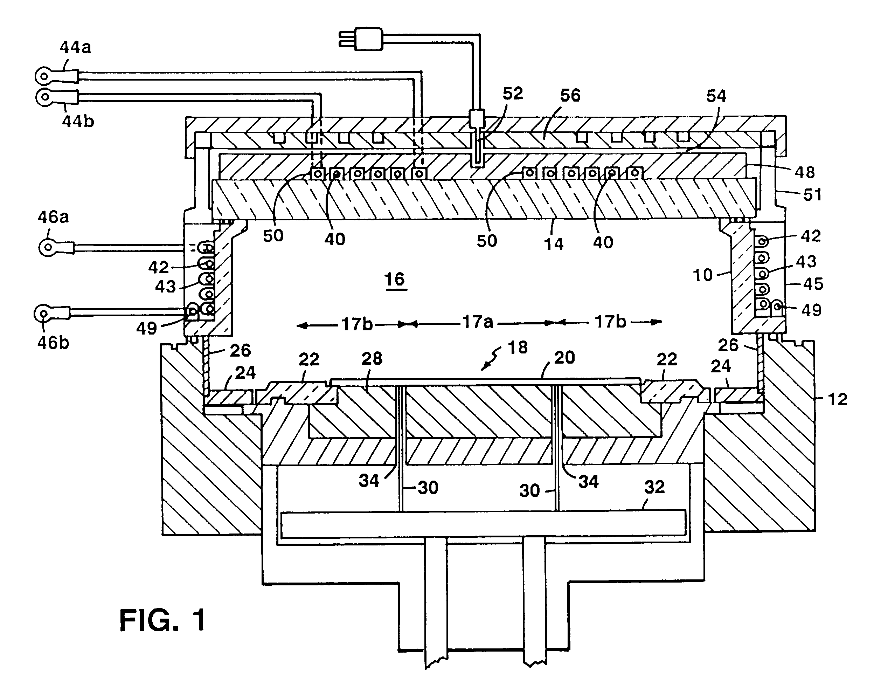

Referring to Fig. 1, a plasma etch system which embodies the invention includes a cylindrical body 10, which is made of a dielectric material (e.g. quartz or a ceramic such as $Al_2O_3$), mounted on top of a metal vacuum chamber body 12. At one end of cylindrical body 10 there is a flange which abuts against and with the aid of an O'rinq forms a vacuum seal with chamber body 12. A circular dielectric plate 14 seals the other end of cylinder 10 thereby forming a sealed cavity 16 in which plasma processing takes place. Both cylindrical body 10 and dielectric plate 14, the combination of which is also generally referred to as a dome, provide windows through which RF power can be coupled into the chamber by appropriately positioned antennas which are described below.

Inside plasma cavity 16 there is an electrostatic chuck assembly (E-chuck) 18 which holds a substrate 20 (e.g. a semiconductor wafer) during processing. The outer perimeter of E-chuck 18 is protected from the corrosive effects of the plasma and from current leakage between the E-chuck and the plasma by a dielectric collar ring 22 that surrounds E-chuck 18. Outside of dielectric collar ring 22, there is an annular plate 24 and around the outer perimeter of plate 24 extending upwards to cylindrical body 10 there is a cylindrically-shaped liner 26. Both annular plate 24 and liner 26 protect the rest of the interior surfaces of the chamber body 12 from the plasma during operation. Annular plate 24 and liner 26 are made of either a dielectric material (e.g. quartz, $Al_2O_3$, or ceramic) or a conductive material (e.g. silicon, silicon carbide, graphite, carbon fiber material, or aluminum, etc.) depending upon the application and other design considerations. In the described embodiment, where top plate 14 is also made completely of a dielectric material, both plate 24 and liner 26 are made of a conductive material so as to provide sufficient conductive area for a return path for the RF bias that is applied to E-chuck. More specifically, annular plate 24 is made of silicon or silicon carbide) and liner 26 is made of a carbon material.

E-chuck 18 includes a metal pedestal 28 with a dielectric/insulating layer formed on its top surface. By applying a voltage to the chuck relative to the plasma that forms above it, the resulting electrostatic field that is formed across the dielectric layer holds the substrate firmly against the top of the chuck. In the described embodiment, a cooling gas (e. g. helium) is supplied through conduits (not shown) within the body of the E-chuck to the backside of substrate 20. Pins 30 that are connected to a movable platform 32 in the bottom of the chamber extend up through holes 34 that pass through E-chuck 18. They are used to lower the substrate onto the E-chuck prior to plasma processing and to lift it off of the E-chuck afterwards. A pneumatic or motor assembly (not shown) located beneath the chamber raises and lowers movable platform 32.

RF power is supplied to plasma cavity through two antennae, namely, a top coil antenna 40 and a side coil antenna 42. Both antennas 40 and 42 are made of copper wire. Top coil antenna 40 is a flat spiral wound coil that is adjacent to the topside of top dielectric plate 14. Side coil antenna 42 is a cylindrically shaped coil that is wound around the outside wall of cylindrical body 10. RF power is supplied to top antenna 40 through two antenna connections 44a and 44b and to side antenna through two other antenna connections 46a and 46b.

An insulator cover plate 48 covers top antenna 40. It includes a groove 50 formed in its bottom surface which has the same spiral shape as top antenna 40 and which completely contains top antenna 40 when cover plate 48 is placed onto top plate 14. Cover plate 48 mechanically holds top antenna 40 in a fixed position relative to the plasma in the chamber and it electrically isolates the turns of the coil from each other so that arcing between turns does not occur. Cover plate 48 includes a heating element 52. Immediately above and adjacent to cover plate 48 there is an air gap 54 and then a water-cooled cooling assembly 56 which acts as a heat sink for the heat that is dissipated by the heated cover plate 48. Heating element 52 and cooling assembly 56 are used to heat or cool and maintain the temperature of cover plate 48 and top plate 14 at a predetermined level during operation.

A cylindrical sleeve 45 surrounds cylindrical body 10. It has grooves 43 formed in its inside surface for holding the turns of side coil antenna 42. Sleeve 45 provides mechanical stability and positioning of the turns relative to the plasma and it provides insulation between turns of the coil which prevents arcing.

Near the bottom of sleeve 45, there is a heater 49 which is used during processing to provide indirect heating to the wall of cylindrical body 10 to stabilize the plasma process. A heat conducting collar 51, which is located above and contacts the top of sleeve 45, provides heat sinking for the heated sleeve by creating a heat flow path up to cooling at the top of the chamber. For example, in some processes it is desirable to heat the chamber wall high enough (e.g. heated to about 200°C) so that polymer precursors that are generated in the chamber end up on the substrate rather than on the wall of the dome.

In the described embodiment, both dielectric sleeve 45 and cover plate 48 are made of a ceramic, e.g. alumina or $Al_2O_3$.

Top antenna 40 delivers RF power in a proportionally larger amount to the center region 17a of cavity 16 as compared to an outer perimeter region 17b that surrounds the center region 17a. If used by itself, top antenna 40 is configured and positioned so it would tend to produce a center-peaked plasma density profile above the surface of substrate 20. In contrast, side antenna 42 delivers RF power in proportionally greater amounts to the outer perimeter region 17b of cavity 16. If used by itself, side antenna 42 is configured and positioned so that it would tend to produce a center-hollow plasma density profile above the surface of substrate 20. When the two antennas 40 and 42 are operated together and the RF power is appropriately divided among them, they tend to cooperate to produce a much more uniform plasma density profile across the top of substrate 20.

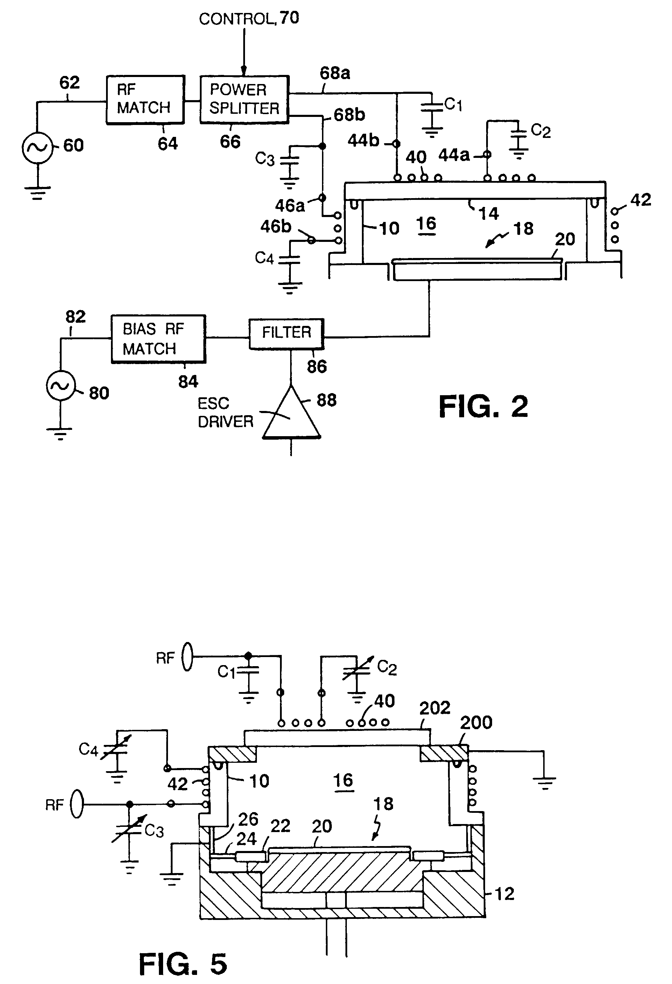

Referring to Fig. 2, in the described embodiment, both antennas 40 and 42 are driven from an RF power source which, in the present embodiment, includes a single RF generator 60. RF generator 60, which has a 50 ohm output impedance, is connected through a 50 ohm coaxial cable 62 to an RF match section 64 and then to a power splitter 66. Power splitter 66 has two output lines 68a and 68b, one connected to one terminal of top coil 40 and the other connected to one terminal of side coil 42. The other terminal of top antenna 40 is connected through a capacitor C2 to ground and similarly, the other terminal of side coil 42 is connected through a capacitor C4 to ground.

In general, RF match section 64 includes one or more variable reactive elements (e.g. inductors or capacitors) by which the impedance of the RF match section can be adjusted to achieve a match condition between RF cable 62 and power splitter 66 to thereby maximize the RF power that is delivered to the plasma within the chamber. An RF detector circuit within RF match section 64 monitors the power transfer into the chamber and generates therefrom control signals which adjust the values of the variable reactance elements within RF match section 64 to achieve and maintain a match condition.

The design and construction of RF match sections which can be used in plasma processing systems are well known to persons skilled in the art. A suitable RF match circuit is described in U.S. 5,392,018 by Collins et al. and a suitable RF match control system is described in U.S. 5,187,454, by Collins et al., both of which are incorporated herein by reference.

Power splitter 66 splits the RF power from the single RF generator to two loads, while maintaining a desired phase relationship between currents or voltages in said loads. Control signal 70 to power splitter 66 enables the user to adjust how the RF power is distributed to the two antennas and thereby control the plasma density profile above the substrate. That is, control signal 70 sets the ratio of the voltages on the two output lines 68a and 68b of power splitter 66. Typically, one might wish to establish a fixed power distribution prior to processing to achieve the desired plasma density profile, e.g. a uniform profile. Alternatively, one might also wish to vary the power distribution during plasma processing and thereby change the plasma density profile in real time. The output signals of the power splitter maintain a relatively constant phase relationship to each other as the voltage ratio between the two output signals is adjusted. In addition, the voltage split ratio is relatively unaffected by dynamic changes in the impedance of the two loads. A suitable RF power splitter is described in U.S. Patent 5,349,313 to Collins et al., incorporated herein by reference.

RF bias power to the E-chuck is supplied by another RF generator 80 which is connected through a coaxial cable 82 to another RF match section 84. The output of RF match section 84 passes through a filter 86 where it is also combined with a DC voltage from a voltage driver 88 for electrostatic chucking. The output signal from filter 86 biases E-chuck 18. The RF signal produces a self-induced bias on E-chuck 18 relative to the plasma. Driver 88 applies an additional DC bias that is used to establish the net DC bias that is appears on E-chuck 18. Filter 86 prevents the RF signal from getting into the DC side of the circuit where it would interfere with its operation.

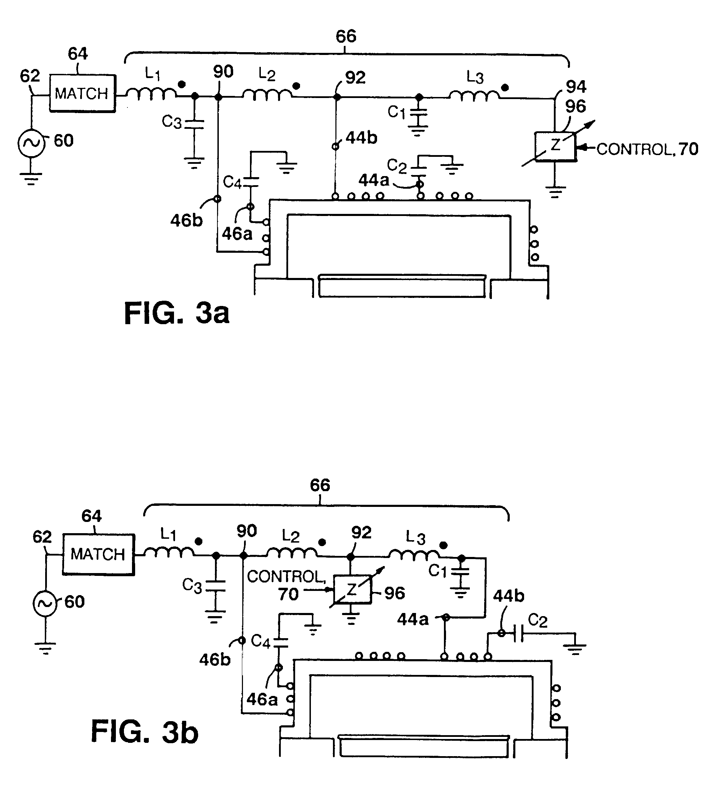

Fig. 3a shows details of the internal design of power splitter 70. As indicated, power splitter 66 is made up of three mutually coupled inductors, L1, L2, and L3, that are connected in series and in phase. A dot at one side of each of the inductors in Fig. 3a represents the inductor terminal which has common phase with the other similarly marked inductor terminals. The coupling coefficient between the three inductors is as high as possible (e.g. 0.8 or better). Inductors L1 and L2 share a common node 90 and inductors L2 and L3 share a common node 92. One terminal of side antenna 42 (e.g. upper terminal 46a) is connected to node 90 and one terminal of top antenna 40 (e.g. outer terminal 44b) is connected to node 92. As noted previously, the other terminals of side antenna 42 and top antenna 40 are connected to ground through capacitors C4 and C2, respectively. Shunt capacitors C3 and C1 are also connected from nodes 90 and 92, respectively, to ground. A variable reactance 96 having a complex impedance Z is connected to the otherwise unconnected terminal of L3 and ground.

RF power is delivered to splitter 66 through the otherwise unconnected terminal if L1 and distributed to both antennas 40 and 42. In this configuration, the output signals to antennas 40 and 42 at node 90 and 92, respectively, are 180° out of phase with each other. Of course, the antenna coils are each wound so that they produce B fields that are aiding each other (e.g. B fields from the two coils along the axial direction of the chamber are in the same direction and thus add), taking into account the 180° phase difference between the input signals to the antennas.

The selection of the precise inductor and capacitor values that are appropriate depends upon many factors including the characteristics of the plasma system and the geometries of the antennas. How to choose appropriate values is well known to persons skilled in the art. Further information that might be useful in this regard can be found in the previously mentioned U.S. Patent 5,349,313 to Collins et al. and in U.S. 5,392,018 to Collins et al., incorporated herein by reference.

Note that in some applications it may also be desirable to wind the coils so that they produce opposing B fields which would generate a cusp-shaped field (or cusp-shaped plasma density profile) above the substrate.

By varying a variable impedance element within reactance element 96, the voltage split ratio between the two coil antennas is controlled, while maintaining a substantially constant phase relationship between the antenna currents and the resulting induced magnetic and electric fields.

Fig. 3b shows an alternative way of configuring power splitter 66 so that the output voltages have 0° phase shift relative to each other. This is done by simply swapping the connections to top antenna 40 and variable reactance element 96. That is, connect variable reactance element 96 to node 92 and connect top antenna 40 to the otherwise unconnected side of inductor L3.

For both configurations shown in Figs. 3a and 3b, there are also various alternative combinations for connecting antennas 40 and 42 to the power splitter and for connecting the terminals of antennas 40 and 42 to power splitter 66. For example, rather than connecting output line 68a to upper terminal 46a it can be connected to lower terminal 46b. Similarly for top antenna 40, rather than connecting output line 68b to outer terminal 44b it can be connected to inner terminal 44a. Other possible ways of making the connections should be readily apparent. Of course, it is desirable to select a particular arrangement of connections so that the B fields that are generated within the chamber aid each other. Thus, the winding direction of the antenna coils will need to be considered when determining which connections are preferable.

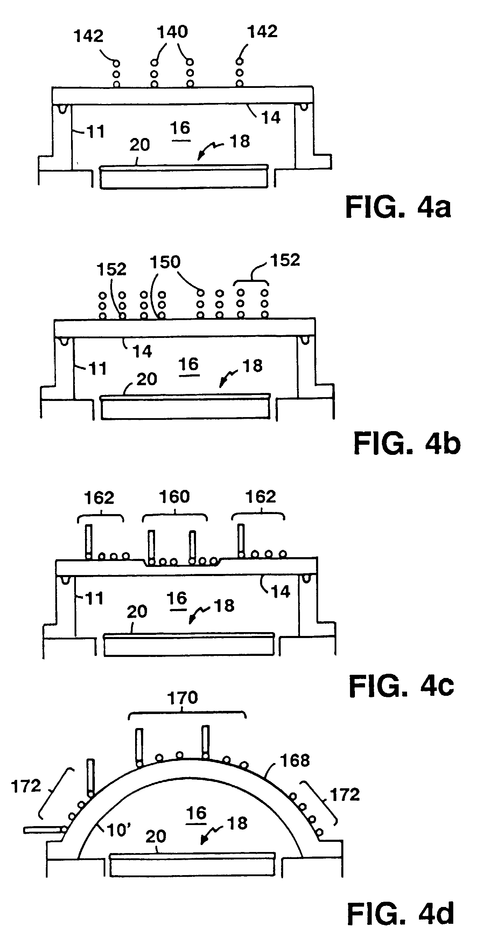

The antenna source geometry may be cylindrical as described or it may be any of a wide variety of alternative geometries. In general, one antenna is designed to produce a center-peaked plasma density profile while the other is designed to produce a hollow-centered plasma density profile so that together they can be operated to generate a more uniform plasma density profile. Examples of alternative source geometries are illustrated in Figs. 4a-d.

Fig. 4a shows a plasma chamber configuration in which two antennas 140 and 142 are located above top plate 14. In this example, both antennas 140 and 142 are cylindrically shaped solenoid type antennas with a single winding. Antenna 140, which is also referred to as the inner antenna tends to deliver RF power to the middle of the chamber thereby producing a center-peaked plasma density profile; while outer antenna 142 tends to deliver power to the outer perimeter of the chamber, thereby producing a center-hollow plasma density profile. Also note that if both antennas are located above the chamber, then one can use a cylindrical body 11 that can be made of metal since it does not need to provide a window through which RF energy can pass into the chamber.

Fig. 4b shows another configuration that is very similar to that of Fig. 4a. It has two antennas, an outer antenna 152 and inner antenna 150, both located above the top plate 14. The difference is that each of the antennas has multiple concentrically-arranged windings.

Fig. 4c shows a configuration which includes two antennas, i.e., an inner antenna 160 and an outer antenna 162, both of which are flat spiral antennas and both of which are mounted above top plate 14 with inner antenna 160 located inside of outer antenna 162. In this configuration, top plate 14 includes an indentation on its top side for receiving inner antenna 160 so that it is closer to the plasma that is generated within the chamber.

Finally, Fig. 4d shows a rounded dielectric dome 168 with a top coil antenna 170 located near the top of the dome and a side coil antenna 172 located near the base of the dome.

In each of the examples described above, the two antennas are separately powered and may be driven by a single RF generator connected to them through a power splitter as previously described, by two phase locked RF generators operating at the same frequency, or by two RF generators at different frequencies.

As should be also readily apparent from the examples shown in Figs. 4a-d, there are many ways in which to configure the dielectric dome and the antennas to exploit the invention described herein. Indeed, one could also use more than two antennas.

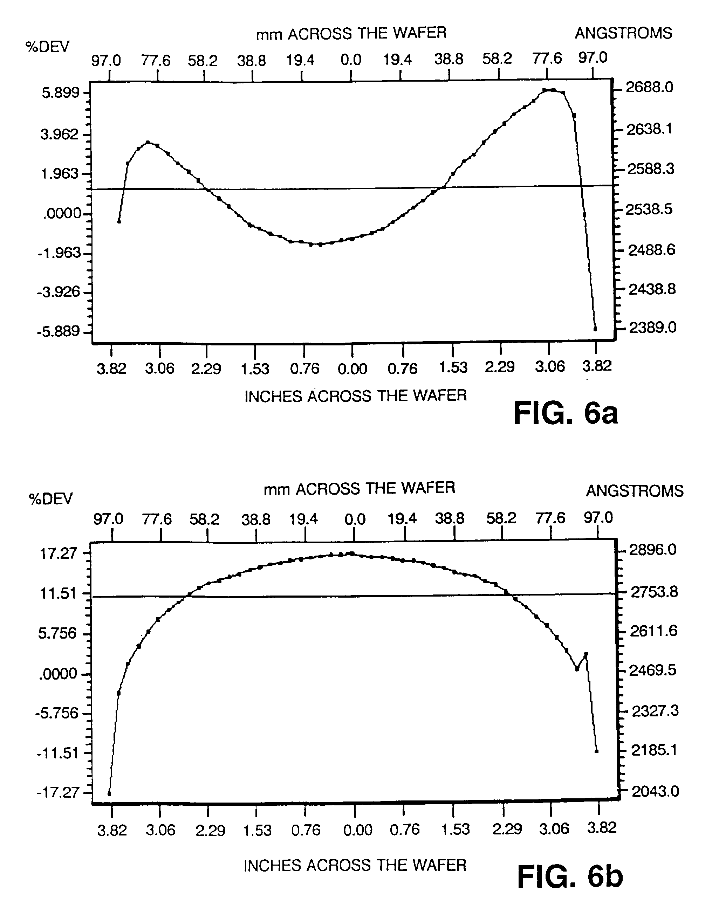

To illustrate the performance of a system which uses the dual coils, specific experimental results will be presented for a plasma etch system configured generally as shown in Fig. 5. Except for the top of the chamber, the system is similar to that shown in Fig. 1, thus many components are numbered the same as corresponding components in the system of Fig. 1. In this embodiment, however, there is a ring 200 which sits atop the cylindrical body 10. It is made of a conductive material (e.g. silicon, SiC, graphite, etc.) and is grounded. It servers to increase the anode area within the chamber so that plasma sheath that is formed next to the anode has a small potential drop across it as compared to the plasma sheath over the substrate and thus sputtering of the anode material will not occur. A dielectric plate 202 sits atop the ring 200 and provides a dielectric window into the chamber for antenna 40.

The relevant dimensions of the system shown in Fig. 5 are as follows:

| Chamber: | 12.5 inches I.D. |
|---|---|
| Cylindrical body: | 2.1 inches tall |
| Top dielectric plate 202: | 0.5 inches thick |
| Conductive ring 200: | 0.5 inches thick |
| | 8.7 inches I.D. |
| Substrate: | 8 inch diameter wafer |

The two antennas had the following characteristics:

| Top antenna 40: | 12 turns, |
|---|---|
| | 8 inches O.D. |
| | 1 inch I.D. |
| | inductance of $\sim$10.96 $\mu$Henries. |
| Side antenna 42: | 5 turns, |
| | 13.5 inches O.D. |
| | 1.5 inches height, and |
| | inductance of $\sim$7.55 $\mu$Henries. |

The capacitors shown in Fig. 5 had the following values:

$$C1 = 2890 \text{ pf}$$

$$C2 = 795 \text{ pf}$$

$$C3 = 5545 \text{ pf}$$

$$C4 = 1011 \text{ pf}$$

A plasma was generated in the system under the following conditions:

No RF bias power
50 sccm Ar flow rate
50 sccm $O_2$ flow rate
5 mTorr servo pressure

With the plasma present in the chamber, ion saturation current density ($J_{ion}$) was measured with a current probe that was placed just above the wafer and biased at -100 volts. The ion saturation current density at two locations, namely, at the center of the wafer and near the edge of the wafer. Measurements were taken for multiple power levels (i.e., 1kW, 2kW, and 3kW) and with different splitter control currents.

The resulting ion saturation current density measurements are presented in the following Table I:

TABLE I

| | | $J_{ion}$ Saturation | | Antenna RF Current | |
|---|---|---|---|---|---|
| P Source | Splitter Control Current | Center of wafer | Edge of 8" wafer | Side | Top |
| 2000 W | 3.9 A | 4.99 mA | 5.43 mA | 67 A p-p | 8 A p-p |
| 2000 W | 5.9 | 6.23 | 5.96 | 51 | 28 |
| 2000 W | 8.3 | 9.04 | 7.62 | 35 | 38 |
| 3000 W | 3.9 | 7.83 | 8.60 | 78 | 11 |
| 3000 W | 5.9 | 10.03 | 9.66 | 58 | 34 |
| 3000 W | 8.3 | 13.50 | 11.84 | 40 | 47 |
| 1000 W | 3.9 | 1.86 | 2.06 | 50 | 7 |
| 1000 W | 5.9 | 2.36 | 2.25 | 38 | 20 |
| 1000 W | 8.3 | 3.72 | 3.29 | 31 | 28 |

As can be readily observed, the ratio of center ion current density to the edge ion current density can be controlled by adjusting the control current for power splitter 66. For example, at power level of 2 kW and with a splitter control current of 3.9 amps, the measured ion current at the center of the wafer was about 10% less than the measured current near the edge, indicating a slight hollow-centered plasma density profile. When the splitter control current was increased to 8.3 amps, the measured ion current density near the center became larger than the measured current density near the edge, indicating that the plasma density profile was no longer hollow-centered.

The measurements at other power levels produced similar results.

Measurements were also made by performing a plasma etch on three oxide-covered wafers, using a different splitter control current for each wafer. These results are presented in Figs. 6a-c, which show net-etched-thickness (i. e., a measurement of the amount of oxide removed) as a function of location along a linear scan across a diameter of the wafer. For these runs the following conditions were used:

Source Power: 2800 W at 2.0 MHz
Bias Power: 1600 W at 1.0 MHz
50 sccm Ar flow rate
50 sccm $O_2$ flow rate
5.0 mTorr servo pressure
3 minute etch time

Fig. 6a shows the etch results that were obtained when the splitter control current was set to 3.9 amps, which produced a power split of about 9:1 for the side antenna relative to the top antenna. In the plots, the lower horizontal axis shows location in inches from the center of the wafer and the vertical axis on the right shows net-etched-thickness (i.e., a measure of the relative amount that was removed by the etch). Note that a y-axis on the left shows percent deviation from a reference etch amount. As can be seen, this particular plasma etch process etched less in the center of the wafer, which is indicative of a hollow-center plasma density distribution.

Fig. 6b shows the etch results that were obtained when the splitter control current was set to 5.9 amps, which produced a power split of about 1:1 for the side antenna relative to the top antenna. In this run, the center etched more than the edges, indicating that the hollow-centered plasma density profile has been eliminated. Indeed, this run is indicative of a plasma density profile that has become somewhat center-peaked.

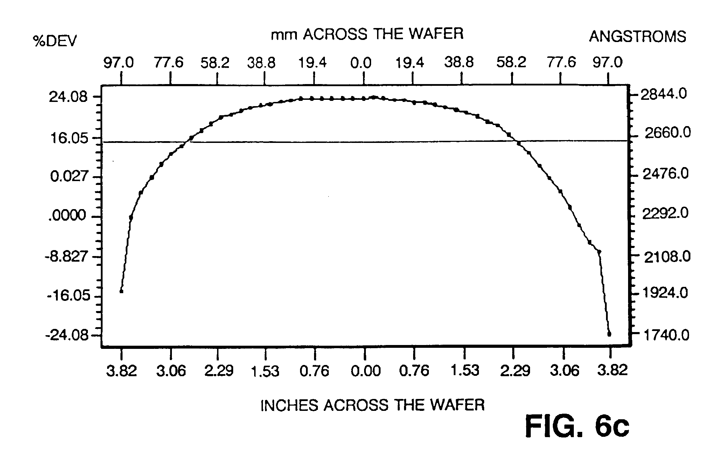

Finally, Fig. 6c shows the etch results that were obtained when the splitter control current was set to 8.3 amps, which produced a power split of about 1:4 for the side antenna relative to the top antenna. This run indicates that the plasma density profile has become even more center-peaked than the one which resulted in the data shown in Fig. 6b.

To achieve a more uniform plasma density profile would require setting the splitter control current at a value somewhere between 3.9 and 5.9 amps. It is also likely that by further modifying the geometry, e.g. the aspect ratio of the chamber, and the characteristics of the coil antennas one could more closely tailor the performance of the system to the requirements of the particular plasma process being performed.

The described embodiment shows using an RF power source that includes a single RF power generator coupled to a power splitter. Alternatively, the power source could include two separate RF power generators operating at the same frequency and provide phase locking circuitry to assure that their frequencies and phases remain locked to each other. Keeping the phases locked assures greater stability and consistency of plasma processing conditions.

Alternatively, one could use two RF power generators set to different frequencies in which case, phase locking would not be appropriate nor required to achieve process stability and consistency. If two RF generators are used at the different frequencies, the frequencies need only be separated by at least few kilohertz before phase locking is no longer necessary. It may be desirable to separate the frequencies by a greater amount to simplify the design of the filtering that will be required in the matching and control circuits for each antenna. In other words, to prevent the signal from one RF generator from interfering with the operation of the RF match and control circuits for the other generator, filters must be used to exclude that other signal. The closer the two frequencies, the more selective and thus the more complex the filtering must be. If the RF frequencies of the two RF generators are separated by about 10% (e.g. 2.0 MHZ and 1.8 MHZ), then the required filtering is relatively easy to implement.

Though the embodiments described above all had the antenna located outside of the chamber, alternatively either or both of the antennas could be located inside of the chamber. For etch processes in which the internal environment is particularly corrosive, it would probably be preferred that the antennas be placed outside of dielectric windows as described above. However, for less hostile processing environments, it may be desirable to place them inside the chamber to achieve more effective coupling to the plasma.

Other embodiments are within the following claims. For example, the multiple, separately powered antennas are well suited for use in the plasma etch systems that are described U.S. patent application U.S.S.N. 08/453,136, filed May 24, 1995 which is a continuation of U.S.S.N. 07/722,340 filed June 27, 1991, both of which are incorporated herein by reference.

**Claims**

1. A plasma system for processing a substrate, said plasma system comprising:

   a chamber body defining a plasma cavity therein;
   a first antenna configured and positioned relative to said plasma cavity so as to produce a center-peaked plasma density profile above the substrate during operation; and
   a second antenna configured and positioned relative to said plasma chamber so as to produce a hollow-centered plasma density profile above the substrate during operation.

2. The plasma system of claim 1 further comprising a power source connected to both the first and the second antennas, said power source delivering power to both the first and second antennas during operation and producing a net plasma density profile above the substrate.

3. The plasma system of claim 2 wherein said power source delivers RF power to both the first and second antennas.

4. The plasma system of claim 3 wherein said power source comprises an RF generator and wherein said plasma system further comprises a power splitter having an input line and a first and a second output line, wherein the input line receives power from the generator, the first output line is coupled to the first antenna, and the second output line is coupled to the second antenna, and wherein said power splitter distributes the power received from the power generator to its first and second output lines.

5. The plasma system of claim 3 wherein said power source comprises a first RF generator delivering power to the first antenna and a second RF generator delivering power to the second antenna.

**6.** The plasma system of claim 1 wherein said first and second antennas are located outside of the plasma cavity.

**7.** The plasma system of claim 6 wherein said chamber body comprises a first dielectric window and a second dielectric window, wherein said first antenna is located outside of said plasma cavity and adjacent to said first dielectric window and wherein said second antenna is located outside of said plasma cavity and adjacent to said second dielectric window.

**8.** The plasma system of claim 7 wherein said first antenna is a coil antenna and said second antenna is a coil antenna.

**9.** The plasma system of claim 7 wherein said first antenna is a flat spiral coil antenna that is located substantially parallel to the substrate during operation.

**10.** The plasma system of claim 7 wherein the second dielectric window is a hollow, cylindrically-shaped body surrounding said plasma cavity and wherein the said second antenna is a cylindrically shaped coil wound around said cylindrically-shaped body.

**11.** The plasma system of claim 10 wherein the first dielectric window is a plate located across one end of said cylindrically-shaped body and wherein said first antenna is located adjacent to said plate.

**12.** The plasma system of claim 11 wherein the cylindrically-shaped body is made of quartz.

**13.** The plasma system of claim 12 wherein the plate is made of quartz.

**14.** The plasma system of claim 6 wherein said chamber body comprises a dielectric window located above the substrate and wherein said first and second antennas are located outside of said plasma cavity and adjacent to said dielectric window.

**15.** The plasma system of claim 14 wherein said second antenna is concentrically positioned within said first antenna.

**16.** A plasma system for processing a substrate, said plasma system comprising:

a chamber body defining a plasma cavity having a central inner region surrounded by an outer region;
a first antenna configured and positioned relative to said plasma cavity so as to couple energy more effectively into the central region than into said outer region; and
a second antenna configured and positioned relative to said plasma chamber so to couple energy more effectively into the outer region than into the central region.

**17.** The plasma system of claim 16 further comprising a power source connected to both the first and the second antennas, said power source delivering power to both the first and second antennas during operation and producing a net plasma density profile above the substrate.

**18.** The plasma system of claim 17 wherein said power source comprises an RF generator and wherein said plasma system further comprises a power splitter having an input line and a first and a second output line, wherein the input line receives power from the generator, the first output line is coupled to the first antenna, and the second output line is coupled to the second antenna, and wherein said power splitter distributes the power received from the power generator to its first and second output lines.

**19.** The plasma system of claim 18 wherein said chamber body comprises a first dielectric window and a second dielectric window, wherein said first antenna is located outside of said plasma cavity and adjacent to said first dielectric window and wherein said second antenna is located outside of said plasma cavity and adjacent to said second dielectric window.

**20.** The plasma system of claim 18 wherein said chamber body comprises a dielectric window located above the substrate and wherein said first and second antennas are located outside of said plasma cavity and adjacent to said dielectric window.

**21.** The plasma system of claim 20 wherein said second antenna is concentrically positioned within said first antenna.

22. A plasma system for processing a substrate, said plasma system comprising:

a chamber body defining a plasma cavity;
a first antenna positioned relative to said plasma cavity so as to couple energy during operation into a plasma within the cavity;
a second antenna positioned relative to said plasma chamber so as to couple energy during operation into the plasma within the cavity;
a power splitter having an input line and a first and a second output line, wherein the first output line is coupled to the first antenna and the second output line is coupled to the second antenna; and
a power generator which provides power to the input line of the power splitter,
wherein said power splitter distributes the power received from the power generator to its first and second output lines.

23. The plasma system of claim 22 wherein the power splitter is responsive to a control signal which determines how the power splitter distributes power to its first and second output lines.

24. The plasma system of claim 22 wherein the power splitter splits the power from the generator to its first and second output lines while maintaining a substantially fixed phase relationship between signals on the first and second output lines.

25. The plasma system of claim 24 wherein said first and second antennas are located outside of the plasma cavity.

26. The plasma system of claim 25 wherein said chamber body comprises a first dielectric window and a second dielectric window, wherein said first antenna is located outside of said plasma cavity and adjacent to said first dielectric window and wherein said second antenna is located outside of said plasma cavity and adjacent to said second dielectric window.

27. The plasma system of claim 26 wherein said first antenna is a coil antenna and said second antenna is a coil antenna.

28. The plasma system of claim 26 wherein said first antenna is a flat spiral coil antenna that is located substantially parallel to the substrate during operation.

29. The plasma system of claim 26 wherein the second dielectric window is a hollow, cylindrically-shaped body surrounding said plasma cavity and wherein the said second antenna is a cylindrically shaped coil wound around said cylindrically-shaped body.

30. The plasma system of claim 27 wherein the first dielectric window is a plate located across one end of said cylindrically-shaped body and wherein said first antenna is located adjacent to said plate.

31. The plasma system of claim 30 wherein the cylindrically-shaped body is made of quartz.

32. The plasma system of claim 31 wherein the plate is made of quartz.

33. The plasma system of claim 25 wherein said chamber body comprises a dielectric window located above the substrate and wherein said first and second antennas are located outside of said plasma cavity and adjacent to said dielectric window.

34. The plasma system of claim 33 wherein said second antenna is concentrically positioned within said first antenna.

35. A method of controlling an ion density profile of a plasma within a plasma system for processing a substrate, said method comprising:

coupling first RF power into the plasma through a first antenna;
coupling second RF power into the plasma through a second antenna; and
controlling a ratio of the first RF power to the second RF power so as to produce a substantially uniform ion density profile above the substrate during plasma processing.

FIG. 1

FIG. 2

FIG. 5

**FIG. 3a**

**FIG. 3b**

FIG. 4a

FIG. 4b

FIG. 4c

FIG. 4d

**FIG. 6a**

**FIG. 6b**

FIG. 6c

EP 0 756 309 A1

## DOCUMENTS CONSIDERED TO BE RELEVANT

**EUROPEAN SEARCH REPORT**

Application Number

EP 96 30 5437

| Category | Citation of document with indication, where appropriate, of relevant passages | Relevant to claim | CLASSIFICATION OF THE APPLICATION (Int.Cl.6) |
|---|---|---|---|
| X | US-A-5 401 350 (PATRICK ROGER ET AL) 28 March 1995<br><br>* column 4, line 60 - column 5, line 22; figure 12 *<br>* column 5, line 49 - column 6, line 11; figure 14 *<br>* column 9, line 31 - column 10, line 2 *<br>--- | 1-10,<br>14-30,<br>33-35 | H01J37/32 |
| A | PATENT ABSTRACTS OF JAPAN<br>vol. 95, no. 009<br>& JP-A-07 161695 (TOKYO ELECTRON LTD), 23 June 1995,<br>* abstract *<br>--- | 1,16,22,<br>35 | |
| P,X | PATENT ABSTRACTS OF JAPAN<br>vol. 96, no. 007<br>& JP-A-08 078191 (KOBE STEEL LTD)<br>* abstract *<br>----- | 1-9,<br>14-28,<br>33-35 | |
| | | | **TECHNICAL FIELDS SEARCHED** (Int.Cl.6)<br><br>H01J |

The present search report has been drawn up for all claims

| Place of search | Date of completion of the search | Examiner |
|---|---|---|
| THE HAGUE | 14 November 1996 | Schaub, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)